# EUROPEAN PATENT SPECIFICATION

(11) **EP 0 467 449 B1**
(45) Date of publication and mention of the grant of the patent: **18.05.1994**
(21) Application number: 91201760.5
(22) Date of filing: 05.07.1991
(51) Int. Cl.: H03L 7/23

(54) **Multiloop microwave frequency synthesizer with low phase noise**
Verschiedene Schleifen enthaltender Mikrowellen-Frequenzsynthetisierer mit niedrigem Phasenrauschen
Synthétiseur de fréquence multi-boucle pour micro-ondes à bruit de phase réduite

(30) Priority: 20.07.1990 IT 2099590
(43) Date of publication of application: 22.01.1992
(73) Proprietor: SIEMENS TELECOMUNICAZIONI S.P.A., 20060 Cassina de Pecchi (Milano) (IT)
(72) Inventor: Buoli, Carlo, I-41030 Mirandola (Modena) (IT); Mora, Giovanni, I-24056 Fontanella (Bergamo) (IT); Ricci, Sergio, I-20063 Cernusco sul Naviglio (Milano) (IT)

(56) References cited:
- EP-A- 0 244 571
- AU-B- 441 816
- DE-A- 3 151 746
- MICROWAVE JOURNAL.vol. 33, no. 7, July 1990, DEDHAM US pages 99 - 104; RONALD C. STIRLING: 'FREQUEMCY SYNTHESIZERS FOR TELEMETRY RECEIVERS'

## Description

The present invention relates to a multiloop microwave frequency synthesizer with low phase noise especially suited as a local oscillator in low capacity transmission systems.

In microwave transmission systems, particularly those with low capacity, the local oscillators must have low phase noise, be temperature stable and protected from frequency jumps caused for example by mechanical stress, to obviate drawbacks such as loss of synchronism of the demodulators and shift-down of the bit error rate (BER).

In addition, in low capacity transmission systems the channellization band is small compared with the carrier frequency and so is the channellization pitch, i.e. the distance between channels; therefore the local oscillator frequency must be synthesized with fine steps and must be very stable.

Different types of frequency synthesizers are known.

A first type of single loop synthesizer with voltage controlled microwave oscillator (VCO), even if capable of synthesizing the oscillation frequency with fine steps, has in reality high phase noise near the carrier and is risky due to the possible onset of frequency jumps.

A second type of synthesizer comprises a microwave dielectric resonator oscillator (DRO) which, while constituting an excellent source as concerns phase noise and frequency jumps, has the shortcoming that it generates a frequency which cannot be changed by synthesis but for a few MHZ without loosing its excellent phase noise and stability characteristics.

Several multiloop frequency synthesizer structures are known and theoretically could solve all the above problems. But said structures are generally very complex and especially costly.

For example, one known type of multiloop microwave synthesizer calls for locking of the oscillator frequency by use of a sampling phase detector (SPD) which is very flexible but has the drawback of requiring that the reference frequency, having low value (e.g. 100 MHz), also have very low phase noise, since the phase noise at the desired microwave frequency (on the order of 5-10GHz) is then worsened in proportion to said reference frequency. The problem is thus one of excessive increase in the complexity and cost of the synthesizer due to the need for obtaining excessively stringent phase noise characteristics.

Another type of multiloop frequency synthesizer is disclosed in the Australian patent AU-B-441816, inventor Raymond Winglee. The syntheszer disclosed comprises a first variable frequency oscillator capable of continuous adjustment for the purpose of frequency selection over a range of frequencies, including first means for selecting an output frequency and second means for adjusting the output frequency over a small range of frequencies about the selected one in response to an electrical signal applied thereto. A first drawback of said synthesizer is that said second means are too expensive and complicated, in fact they include a highly-stable oscillator (9), a frequency divider, a phase comparator, two crystal-controlled oscillators (11, 12) differentially drived, and a mixer (13). A second important drawback is that the phase noise of the output frequency generated is still too hig.

Accordingly the purpose of the present invention is to overcome the above shortcomings and indicate a low cost multiloop microwave frequency synthesizer, occupying little space, having low phase noise and high frequency jump immunity and particularly suited as a local oscillator in low capacity transmission systems.

The synthesizer comprises essentially a microwave frequency synthesizer loop, a wide step programmable frequency synthesizer loop and a fine step programmable frequency synthesizer loop all provided and interconnected in a particularly efficient manner.

To achieve said purposes the object of the present invention is a multiloop microwave frequency synthesizer with low phase noise as described in claim 1.

Other objects and advantages of the present invention will be clarified by the detailed description given below of an example of embodiment thereof given merely by way of nonlimiting example with reference to the annexed drawings wherein:
FIG. 1 shows the circuit block diagram of the multiloop frequency synthesizer which is the object of the invention, and
FIGS. 2 and 3 show the trend of the phase noise with the frequency deviation from the carrier in some blocks of the synthesizer.

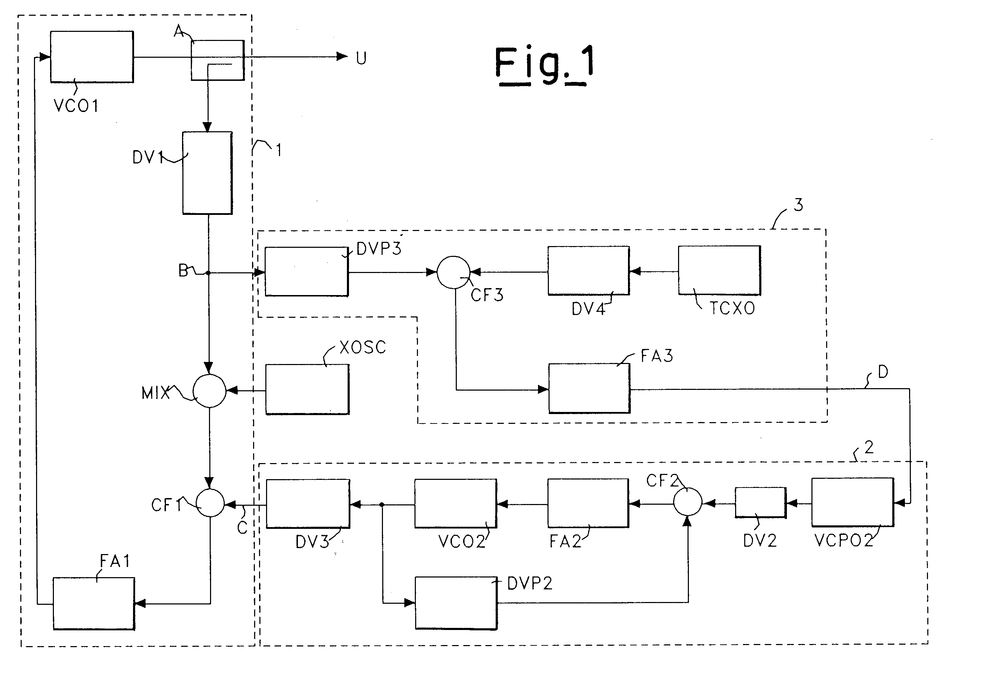

With reference to FIG. 1 the synthesizer comprises essentially a microwave frequency synthesizer loop consisting of the blocks enclosed in the broken line 1, a wide step programmable frequency synthesizer loop consisting of the blocks enclosed in the broken line 2, and a fine step programmable frequency synthesizer loop consisting of the blocks enclosed in the broken line 3 and of an equivalent oscillator of the loops 1 and 2 seen, at points B and D.

The loop 1 consists of the circuit blocks described below.

VCO1 indicates a voltage controlled microwave oscillator with output frequency of approximately 3.6GHz, band of approximately 100MHz and merit factor Q≈50 provided in a known manner, e.g. using a microwave bipolar transistor and varactor diode, controlling the oscillation frequency, on an alumina substrate.

DV1 indicates a divider by 16 of the output frequency of VCO1 which it receives through, for example, a microstrip directional coupler A of known type. Given the high input frequency, DV1 consists of a cascade of two dividers by 4, of which the high frequency one is embodied by with the component AVANTEK® IFD-50010.

MIX indicates a common mixer of the frequency of the output B of DV1 (approximately 225MHz) and of a normal 220MHz XOSC quartz oscillator.

The MIX output with a frequency of approximately 5MHz enters in an input of a normal phase comparator CF1 to whose second input is brought the output C of the secondary loop 2 which also has a frequency of approximately 5MHz.

The output of CF1 is brought to a normal loop filter FA1 of the second order having cutoff frequency of approximately 50kHz and which pilots the varactor diode of the microwave oscillator VCO1.

The loop 2 which fulfils the function of wide step programmable frequency synthesizer (1MHz) consists of the following circuit blocks.

VCO2 indicates a voltage controlled oscillator in the range 60-120MHz consisting of a normal VHF oscillator with LC components and bipolar transistors BJT with low merit factor Q≈10.

DVP2 indicates a normal programmable divider which divides the output frequency of VCO2 by a number N2 settable from the outside and variable from 60 to 120 approximately, obtaining at the output a frequency of approximately 1MHz.

VCPO2 indicates a voltage controlled piezoelectric oscillator with nominal frequency of 8MHz embodied in the normal manner with a bipolar transistor, a varactor diode for control of the oscillation frequency and a piezoelectric resonant cavity with merit factor characteristics of Q≈1000 and frequency change of ±100kHz.

The output frequency of VCPO2 is divided by 8 by a normal divider DV2.

A common phase comparator CF2 compares the phases of the output signals of the dividers DVP2 and DV2 and supplies a phase error signal to a normal loop filter FA2 of the second order with cutoff frequency of approximately 50kHz which pilots the varactor diode of the oscillator VCO2.

The output frequency of VCO2 is divided by 16 in a normal divider DV3 whose output C is applied to an input of the phase comparator CF1.

With nominal output frequency of VCPO2 of 8MHz, i.e. output frequency of DV2 of 1MHz, by programming DVP2 there are obtained steps of 1MHz at the output of VCO2 and hence steps of 1/16MHz at the output of DV3. Since the output frequency of VCO1 is also divided by 16 by DV1, the result is a synthesis step of the loop 1 having 1MHz at the output of VCO1 if controlled only by the programming of the loop 2. The loop 2 thus controls generation of the synthesis steps 1MHz wide and also determines the band width of the synthesizer set by the band of the oscillator VCO2 (approximately 60MHz).

The loop 3 fulfils the function of microwave fine step programmable frequency synthesizer and consist of the following circuit blocks.

DVP3 indicates a normal programmable divider which divides the output frequency of the divider DV1 by a number N3 settable from the outside and variable in such a manner as to obtain fine synthesis steps of approximately 3.9kHz at point B which, due to the presence of the multiplier by 16 DV1, give rise to steps of 62.5kHz at the output of the oscillator VCO1 (equal to the distance between the carriers of the low capacity transmission system channels).

TXCO indicates an oscillator with a reference frequency of 8MHz embodied in a known manner by means of a quartz oscillator and a varactor diode, controlling the oscillation frequency, controlled by a temperature compensation network such as to assure a stability of ±2ppm between -40°C and +80°C.

TCXO determines the behaviour of the entire synthesizer which is the object of the invention as regards temperature and aging.

A normal divider DV4 divides the output frequency of TXCO by 2048 and feeds a first input of a phase comparator CF3 to whose second input is brought the output of the divider DVP3.

A normal loop filter FA3 with low cutoff frequency of 100Hz receives the output of CF3 and generates a control signal D for the varactor diode of the oscillator VCPO2.

The circuit of the loop 3 "sees" between the points B and D an equivalent oscillator whose frequency is that of the output of DV1. i.e. given by the microwave oscillation of VCO1 divided by 16 by DV1 and programmed with wide step by the loop 2 and with fine steps by the loop 3.

Hence the loop 3 determines the fine synthesis step of the microwave synthesizer (62.5kHz) and also compensates for the various drifts (temperature, long term).

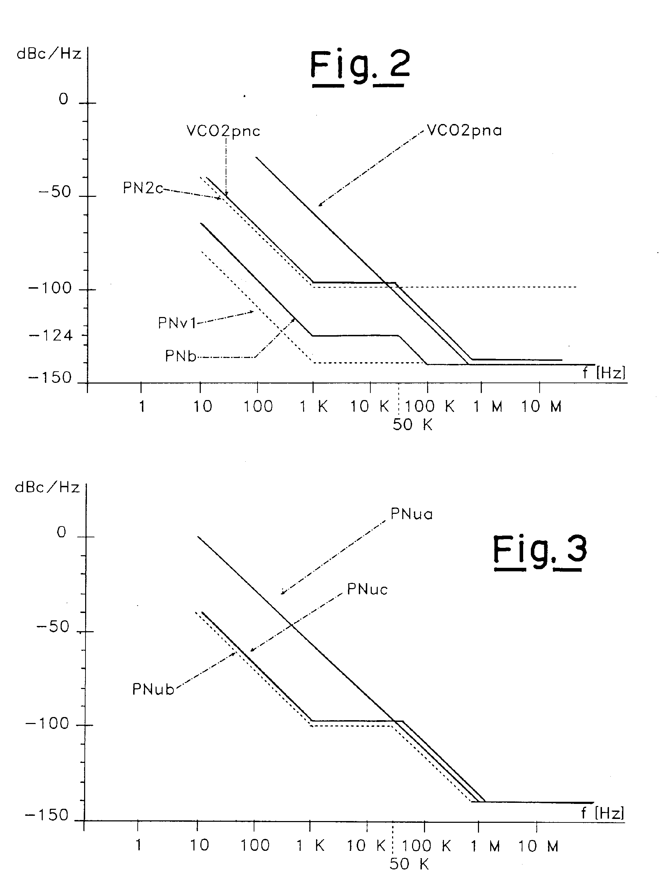

Now let us consider the behaviour of the synthesizer as regards phase noise with reference to FIGS. 2 and 3 which show the trend of the phase noise as a function of the frequency deviation from the carrier for some components.

In general it can be seen from the figures that the phase noise decreases as frequency deviation increases. Let us suppose that it is desired to obtain a phase noise value of PNu ≦ -100dBc/Hz at the frequency deviation of 1kHz from the carrier, at the microwave output U of the synthesizer, a characteristic which may be considered good.

This means that at the output of DV1, at point B (FIG. 1), there must be a phase noise of at least PNb ≦ -124 = PNu - 20log16 dBc/Hz, i.e. a phase noise decreased by the division factor of DV1.

The oscillator VCPO2 introduces a phase noise PNv < -130 dBc/Hz which is decreased passing through the divider DV2 and obtaining at the input of CF2 a phase noise PNv1 < PNv - 20log8 = -148 dBc/Hz. In addition the very low cutoff frequency of the filter FA3 provides that on the control signal of VCPO2 at point D there is no appreciable contribution of phase noise generated by the portion of the loop 3 included between the points B and D. The amount of phase noise present at the output of DV2 is thus negligible.

The oscillator XOSC introduces a phase noise PNx < -130 dBc/Hz, while the contribution of the mixer MIX and the loop filter FA1 is PNmf < -140 dBc/Hz. Since said contributions to phase noise are smaller than the desired value, the behaviour of the loop 2 and hence of the oscillator VCO2, whose phase noise curve is shown in FIG. 2 in both cases, i.e. with open loop VCO2pna and closed loop 2 VCO2pnc, plotted with unbroken lines, is decisive. At the lower frequency deviations, the closed loop trend follows that of the broken line PN2c for the phase noise coming from the feedback leg comprising the divider DVP2 and follows the open loop trend at the higher frequency deviations.

The divider DV3 causes a decrease of 24dB in the noise at its output at point C, as shown by the trend of the curve PNb, compared with the noise present at its input (curve VCO2pnc). The curve PNb also represents the phase noise at point B since, as already mentioned, the contribution to the noise of the other components is negligible and this is what it was desired to achieve. PNb has the value -124 dBc/Hz at the frequency deviation of 1kHz. It can easily be seen that the phase noise of VCO2, in the path to the point U, is as though divided at DV3 and then multiplied at DV1 by the same value (16), thus obtaining that the phase noise curve of VCO2 is transferred to point U. This behaviour is also verified experimentally, as shown in FIG. 3, wherein is shown in unbroken line the trend of the phase noise at the output U in both cases, indicated in unbroken lines, of open loop 1 PNua and closed loop 1 PNuc. It can be seen that the curve PNuc is equivalent to the broken line curve of FIG. 3 PNub which brings back to the input of the divider DV1 the phase noise PNb present at its output.

The behaviour of the synthesizer in the presence of the phase noise of the synthesizer is thus determined by VCO2.

As regards the behaviour of the synthesizer in the presence of frequency jumps the following can be said. Said jumps are caused essentially by external mechanical stresses on the oscillators and translate into corresponding frequency variations around the nominal value which are smoothed dependant upon the gain of the associated loop. In our case the loop 1 is of the second order and the loop gain has a zero at approximately 50kHz of deviation from the carrier frequency, thus allowing smoothing of all the disturbances below said cutoff frequency.

The oscillators XOSC and VCPO2 are also mounted in a mechanically shock absorbed metallic container.

The above description makes clear the advantages obtained with the present invention, especially in terms of low cost due to the use of normal components and technology and in terms of small size due to the use of few components while simultaneously achieving good characteristics of phase noise, compression of frequency jumps and fine synthesis of the oscillation frequency.

## Claims

1. Multiloop microwave frequency synthesizer comprising a main loop (1) which synthesizes a frequency over a wide range of frequencies, and means for programming the value of the synthesized frequency with wide or fine steps, and in which:
said main loop (1) includes a microwave first voltage controlled oscillator (VCO1), a first frequency divider (DV1), a mixer (MIX), a first phase comparator (CF1) and a first loop filter (FA1) arranged in cascade, said mixer (MIX) subtracting a first reference frequency generated by a first reference oscillator (XOSC) from the output frequency of the first divider (DV1), obtaining a mixed signal which feeds one input of the first phase comparator (CF1) whose second input is fed with a second reference frequency generated by said wide step programming means (2), the first phase comparator generating a first error signal to control the first voltage controlled oscillator (VCO1) which generates a programmed synthesized frequency;
said wide steps programming means, arranged in a secondary loop (2), comprise a second voltage controlled oscillator (VCO2), a first programmable frequency divider (DVP2), a second phase comparator (CF2) and a second loop filter (FA2) arranged in cascade, the output frequency of the first programmable frequency divider (DVP2) feeding one input of the second,phase comparator (CF2) whose second input is fed with a wide-step reference frequency generated by a third voltage controlled oscillator (VCPO2), said second phase comparator (CF2) generating a second error signal to control the second voltage controlled oscillator (VCO2) in order to generate said second reference frequency; and
said fine steps programming means (3) include a second programmable frequency divider (DVP3) dividing said output frequency of the first divider (DV1) obtaining a fine-step incremental frequency feeding a first input of a third phase comparator (CF3), whose second input is fed by a fine-step reference frequency generated by a second reference oscillator (TCXO), the third phase comparator (CF3) generating a third error signal to control through a third loop filter (FA3) said third voltage controlled oscillator (VCPO2) which generates said wide-step reference frequency.

2. Multiloop microwave frequency synthesizer as in claim 1, characterized in that said wide steps programming means (2) also include:
a second frequency divider (DV3) dividing the output frequency of said second voltage controlled oscillator (VCO2) obtaining said second reference frequency for the main loop (1);
a third frequency divider (DV2) dividing the output frequency of said third voltage controlled oscillator (VCPO2) obtaining said wide-step reference frequency.

3. Multiloop microwave frequency synthesizer as in claim 2, characterized in that said second frequency divider (DV3) divides said output frequency of the second voltage controlled oscillator (VCO2) by a dividing value equal to the dividing value of the first frequency divider (DV1), such as the band width and the phase noise of the main loop (1) respectively coincide with the oscillation frequency band and the phase noise of the second voltage controlled oscillator (VCO2).

4. Multiloop microwave frequency synthesizer as in claim 1, characterized in that said second voltage controlled oscillator (VCO2) of the secondary loop (2) has a low merit factor.

5. Multiloop microwave frequency synthesizer as in claim 1, characterized in that said third voltage controlled oscillator (VCPO2) consists of a voltage controlled oscillator with piezoelectric resonant cavity.

6. Multiloop microwave frequency synthesizer as in claim 1, characterized in that the temperature stability is determined by said second reference oscillator (TCXO) which comprises a temperature compensation network.

7. Multiloop microwave frequency synthesizer as in claim 1, characterized in that the dividing value of said first frequency divider (DV1) is equal to 16, and said first reference frequency generated by said first reference oscillator (XOSC) is equal to 220 MHz so as to obtain said mixed signal with a frequency equal to approximately 5 MHz.

## Patentansprüche

1. Verschiedenen Schleifen enthaltender Mikrowellen-Frequenzsynthetisierer, mit einer Hauptschleife (1), die eine Frequenz über ein weites Frequenzband synthetisiert, sowie einer Schaltung, mit der der Wert der synthetisierten Frequenz in groben oder feinen Schritten programmiert werden kann, und in dem:
die genannte Hauptschleife (1) einen ersten spannungsgesteuerten Mikrowellen-Oszillator (VCO1), einen ersten Frequenzteiler (DV1), einen Mischer (MIX), einen ersten Phasenvergleicher (CF1) und ein erstes Schleifenfilter (FA1) in Kaskandenschaltung einschließt, in welcher der genannte Mischer (MIX) eine erste von einem Referenzoszillator (XOSC) erzeugte Referenzfrequenz von der Ausgangsfrequenz des ersten Frequenzteilers (DV1) subtrahiert, wobei ein Mischsignal entsteht, das an einen Eingang des ersten Phasenvergleichers (CF1) übertragen wird, an dessen zweiten Eingang eine zweite von der genannten Programmierschaltung (2) erzeugte Referenzfrequenz weitergeleitet wird, wobei der erste Phasenvergleicher ein erstes Fehlersignal zur Steuerung des ersten spannungsgesteuerten Oszillators (VCO1) abgibt, der eine programmierte synthetische Frequenz erzeugt;
die genannte in einer Sekundärschleife (2) angeordnete grobschrittige Programmierschaltung einen zweiten spannungsgesteuerten Oszillator (VCO2) enthält, sowie einen ersten programmierbaren Frequenzteiler (DVP2), einen zweiten Phasenvergleicher (CF2) und ein zweites Schleifenfilter in Kaskadenschaltung (FA2), wobei die Ausgangsfrequenz des ersten programmierbaren Frequenzteilers (DVP2) an einen Eingang des zweiten Phasenvergleichers (CF2) weitergeleitet wird, an dessen zweiten Eingang eine grobschrittige, von einem dritten spannungsgesteuerten Oszillator (VCPO2) erzeugte Frequenz weitergeleitet wird, wobei der zweite Phasenvergleicher (CF2) ein zweites Fehlersignal zur Steuerung des zweiten spannungsgesteuerten Oszillatyors (VCO2) erzeugt, sodaß die genannte zweite Referensfrequenz entsteht; und
die genannte feinschrittige Programmierschaltung (3) einen zweiten programmierbaren Frequenzteiler (DVP3) enthält, der die genannte Ausgangsfrequenz des ersten Frequenzteilers (DV1) aufteilt, wodurch eine in feinen Schritten anwachsende Frequenz entsteht, die an den ersten Eingang eines dritten Phasenvergleichers (CF3) weitergeleitet wird, an dessen zweiten Eingang eine von einem zweiten Referenzoszillator (TCXO) erzeugte feinschrittige Referenzfrequenz übertragen wird, wobei der dritte Phasenvergleicher (CF3) ein drittes Fehlersignal erzeugt, das über ein drittes Schleifenfilter (FA3) den genannten dritten spannungsgesteuerten Oszillator (VCPO2) steuert, der die genannte grobschrittige Referenzfrequenz erzeugt.

2. Verschiedene Schleifen enthaltender MW-Frequenzsynthetisierer wie in Anspruch 1, **dadurch gekennzeichnet,** daß die genannte grobschrittige Programmierschaltung (2) ebenfalls folgendes enthält:
einen zweiten Frequenzteiler (DV3), der die Ausgangsfrequenz des genannten zweiten spannungsgesteuerten Oszillators (VCO2) teilt, sodaß sie genannte zweite Referenzfrequenz für die Hauptschleife (1) entsteht;
einen dritten Frequenzteiler (DV2), der die Ausgangsfrequenz des genannten dritten spannungsgesteuerten Oszillators (VCPO2) teilt, sodaß die genannte grobschrittige Referenzfrequenz entsteht.

3. Verschiedene Schleifen enthaltender MW-Frequenzsynthetisierer wie in Anspruch 2, **dadurch gekennzeichnet**, daß der genannte zweite Frequenzteiler (DV3) die genannte Ausgangsfrequenz des zweiten spannungsgesteuerten Oszillators (VCO2) durch einen Divisionswert teilt, der gleich dem Divisionswert des ersten Frequenzteilers (DV1) ist, sodaß die Bandbreite und das Phasenrauschen der Hauptschleife (1) jeweils mit dem Frequenzband und dem Phasenrauschen des zweiten spannungsgesteuerten Oszillators (VCO2) übereinstimmen.

4. Verschiedene Schleifen enthaltender MW-Frequenzsynthetisierer wie in Anspruch 1, **dadurch gekennzeichnet**, daß der genannte zweite spannungsgesteuerte Oszillators (VCO2) der Sekundärschleife (2) einen niedrigen Gütewert hat.

5. Verschiedene Schleifen enthaltender MW-Frequenzsynthetisierer wie in Anspruch 1, **dadurch gekennzeichnet**, daß der genannte dritte spannungsgesteuerte Oszillators (VCPO2) aus einem spannungsgesteuerten Oszillator mit piezoelektrischem Hohlraumresonator besteht.

6. Verschiedene Schleifen enthaltender MW-Frequenzsynthetisierer wie in Anspruch 1, **dadurch gekennzeichnet**, daß die Temperaturstabilität durch den genannten zweiten Referenzoszillator (TCXO) bestimmt wird, der ein Netzwerk zur Temperatuirkompensation enthält.

7. Verschiedenen Schleifen enthaltender
MW-Frequenzsynthetisierer wie in Anspruch 1, **dadurch gekennzeichnet**, daß der Divisionswert des ersten Frequenzteilers (DV1) gleich 16 ist und die genannte von dem ersten Referenzoszillator (XOSC) erzeugte erste Referenzfrequenz gleich 220 MHz ist, sodaß ein Mischsignal mit einer Frequenz von eta 5 MHz entsteht.

## Revendications

1. Synthétiseur de fréquence multi-boucle pour micro-ondes comprenant une boucle principale (1) qui synthétise une fréquence parmi une vaste gamme de fréquences, et des moyens pour programmer la valeur de la fréquence synthétisée par pas grossiers ou fins, et dans lequel:
ladite boucle principale (1) comporte un premier oscillateur hyperfréquence commandé en tension (VCO1), un premier diviseur de fréquence (DV1), un mélangeur (MIX), un premier comparateur de phase (CF1) et un premier filtre de boucle (FA1) disposés en cascade, ledit mélangeur (MIX) soustrayant une première fréquence de référence générée par un premier oscillateur de référence (XOSC) à partir de la fréquence de sortie du premier diviseur (DV1), produisant un signal mixte qui alimente une entrée du premier comparateur de phase (CF1) à la deuxième entrée duquel est alimentée une deuxième fréquence de référence générée par ledit moyen de programmation par pas grossiers (2), le premier comparateur de phase générant un premier signal d'erreur pour commander le premier oscillateur commandé en tension (VCO1) qui génère une fréquence synthétisée programmée;
ledit moyen de programmation par pas grossiers, disposé en une boucle secondaire (2), comprend un deuxième oscillateur commandé par tension (VCO2), un premier diviseur de fréquence programmable (DVP2), un deuxième comparateur de phase (CF2) et un deuxième filtre de boucle (FA2) disposés en cascade, la fréquence de sortie du premier diviseur de fréquence programmable (DVP2) alimentant une entrée du deuxième comparateur de phase (CF2) à la deuxième entrée duquel est alimentée une fréquence de référence par pas grossier générée par un troisième oscillateur commandé en tension (VCPO2), ledit deuxième comparateur de phase (CF2) générant un deuxième signal d'erreur pour commander ledit deuxième oscillateur commandé en tension (VCO2) afin de générer ladite deuxième fréquence de référence; et
ledit moyen de programmation par pas fins (3) comprend un deuxième diviseur de fréquence programmable (DVP3) divisant ladite fréquence de sortie du premier diviseur (DV1) produisant une fréquence incrémentielle par pas fins alimentant une première entrée d'un troisième comparateur de phase (CF3), à la deuxième entrée duquel est alimentée une fréquence de référence par pas fin générée par un deuxième oscillateur de référence (TCXO), le troisième comparateur de phase (CF3) générant un troisième signal d'erreur pour commander par l'intermédiaire d'un troisième filtre de boucle (FA3) ledit troisième oscillateur commandé en tension (VCPO2) qui génère ladite fréquence de référence par pas grossier.

2. Synthétiseur de fréquence multi-boucle pour micro-ondes selon la revendication 1, caractérisé en ce que ledit moyen de programmation par pas grossiers (2) comprend également:
un deuxième diviseur de fréquence (DV3) qui divise la fréquence de sortie dudit deuxième oscillateur commandé en tension (VCO2) produisant ladite deuxième fréquence de référence pour la boucle principale (1);
un troisième diviseur de fréquence (DV2) qui divise la fréquence de sortie dudit troisième oscillateur commandé en tension (VCPO2) produisant ladite fréquence de référence de pas grossier.

3. Synthétiseur de fréquence multi-boucle pour micro-ondes selon la revendication 2, caractérisé en ce que ledit deuxième diviseur de fréquence (DV3) divise ladite fréquence de sortie du deuxième oscillateur commandé en tension (VCO2) par une valeur de division égale à la valeur de division du premier diviseur de fréquence (DV1), de sorte que la largeur de bande et le bruit de phase de la boucle principale (1) respectivement coïncident avec la bande de fréquence d'oscillation et le bruit de phase du deuxième oscillateur commandé en tension (VCO2).

4. Synthétiseur de fréquence multi-boucle pour micro-ondes selon la revendication 1, caractérisé en ce que ledit deuxième oscillateur commandé en tension (VCO2) de la boucle secondaire (2) a un facteur de qualité de transmission faible.

5. Synthétiseur de fréquence multi-boucle pour micro-ondes selon la revendication 1, caractérisé en ce que ledit troisième oscillateur commandé en tension (VCPO2) consiste en un oscillateur commandé en tension avec une cavité résonnante piézoélectrique.

6. Synthétiseur de fréquence multi-boucle pour micro-ondes selon la revendication 1, caractérisé en ce que la stabilité thermique est déterminée par ledit deuxième oscillateur de référence (TCXO) qui comprend un réseau de compensation thermique.

7. Synthétiseur de fréquence multi-boucle pour micro-ondes selon la revendication 1, caractérisé en ce que la valeur de division dudit premier diviseur de fréquence (DV1) est égale à 16, et ladite première fréquence de référence générée par ledit premier oscillateur de référence (XOSC) est égale à 220 MHz de manière à produire ledit signal mélangé avec une fréquence égale à environ 5 MHz.
